# EUROPEAN PATENT APPLICATION

(11) **EP 1 564 311 A1**
(43) Date of publication of application: **17.08.2005**
(21) Application number: 03748750.1
(22) Date of filing: 07.10.2003
(51) Int. Cl.: C23C 28/00

(54) **STABILIZED ALUMINUM LAMINATE HAVING ALUMINUM AND STABILIZING LAYER LAMINATED THEREON**

(30) Priority: 25.10.2002 JP 2002311001
(71) Applicant: FCM Co., Ltd., Osaka-shi, Osaka 537-0003 (JP)
(72) Inventor: MIURA, Shigeki, FCM Co., Ltd., Higashinari-ku,Osaka-shi, Osaka 537-0003 (JP)
(74) Representative: Grünecker, Kinkeldey, Stockmair & Schwanhäusser
(86) International application number: PCT/JP2003/012851
(87) International publication number: WO 2004/038065

(57) **Abstract**

An aluminum stabilization stacked body (101) formed by stacking a stabilization layer (103) formed with a metal and having a thickness of 0.001-1 µm with any of a sputtering method, a deposition method and an ion plating method on a whole surface of a thin film (102) having a surface formed with aluminum.

## Description

### Technical Field

The present invention relates to a technique for stabilizing a surface formed with aluminum in an aluminum-based material used in any technical field such as electrical and electronic parts, a semiconductor circuit or a product related to an automobile. More specifically, the present invention relates to an aluminum stabilization stacked body having dramatically enhanced electrical resistance, corrosion resistance or decorativeness by stabilizing a surface formed with aluminum in any kind of aluminum-based material used for wiring, electrical conduction, a circuit, bonding, soldering, a contact (such as a contact point, a connector, a relay or a switch), shielding, decoration, or the like.

### Background Art

Plating of a surface of aluminum with various metals has been performed for the purpose of giving or improving electrical resistance, corrosion resistance or decorativeness. However, since aluminum, as is well-known, is very susceptible to oxidation, the surface is unstable and immediately reacts with oxygen in air or the like to form aluminum oxide. Therefore, electroless plating or electroplating cannot be performed in similar conditions as other materials, and highly tortuous and complex processing has been required. That is, the surface of aluminum is first washed and degreased, then an unevenness is provided by etching, followed by zinc substitution processing and formation of a conductive layer having a thickness of several µm, and thereafter, plating is performed. Accordingly, stabilization of the surface of aluminum with a simple method has been demanded in various technical fields not only for the plating of the surface but also from a standpoint of decoration, that is, for keeping an aesthetic appearance thereof. Under present circumstances, however, a technique which meets the demand has not been found.

Japanese Patent Laying-Open No. 2001-14959 describes a superconducting conductor having a surface of an aluminum wire covered with a Cu-Ni alloy. This invention, however, relates to the aluminum wire and not to a thin film formed with aluminum. Therefore, there is no reference to a technique for stabilizing a surface of the thin film.

In addition, Japanese Patent Laying-Open No. 10-96087 describes a cylinder for an internal combustion engine having a surface of the cylinder, which is made of aluminum, covered with a copper alloy. This invention, however, relates to the cylinder made of aluminum and not to the thin film formed with aluminum. Therefore, there is no reference to a technique for stabilizing the surface of the thin film.

In addition, Japanese Patent Laying-Open No. 5-109328 describes an aluminum stabilization material for a superconducting conductor having a periphery of high purity aluminum covered with copper. This invention, however, relates to aluminum in a form of a wire and not to the thin film formed with aluminum. Therefore, there is no reference to a technique for stabilizing the surface of the thin film.

### Disclosure of the Invention

The present invention is made in view of such present circumstances. An object of the present invention is to provide an aluminum stabilization stacked body having a surface of aluminum stabilized with a simple method in an aluminum-based material used for electrical and electronic parts, a semiconductor circuit, a product related to an automobile, or the like.

With a thorough study by the inventor to solve the above-described problem, it was found out that aluminum is stabilized by protecting a surface formed with aluminum with an unprescribed metal. A further study continued based on the finding has finally brought the present invention to perfection.

That is, the present invention relates to an aluminum stabilization stacked body formed by stacking a stabilization layer formed with a metal and having a thickness of 0.001-1 µm with any of a sputtering method, a deposition method and an ion plating method on a whole surface of a thin film having a surface formed with aluminum.

In addition, the thin film having the surface formed with aluminum can be aluminum foil rolled to have a thickness of 4-200 µm.

In addition, the metal can be any of Cu, Ni, and an alloy including Cu and/or Ni.

In addition, a plated layer can be stacked on a surface of the stabilization layer.

### Brief Description of the Drawings

Fig. 1 is a schematic cross-sectional view of an aluminum stabilization stacked body.
Fig. 2 is a schematic cross-sectional view of an aluminum stabilization stacked body having a thin film having a surface formed with aluminum which is formed by affixing aluminum foil to a polymer film.
Fig. 3 is a schematic cross-sectional view of an aluminum stabilization stacked body having a plated layer stacked on a surface of a stabilization layer.

### Best Modes for Carrying Out the Invention

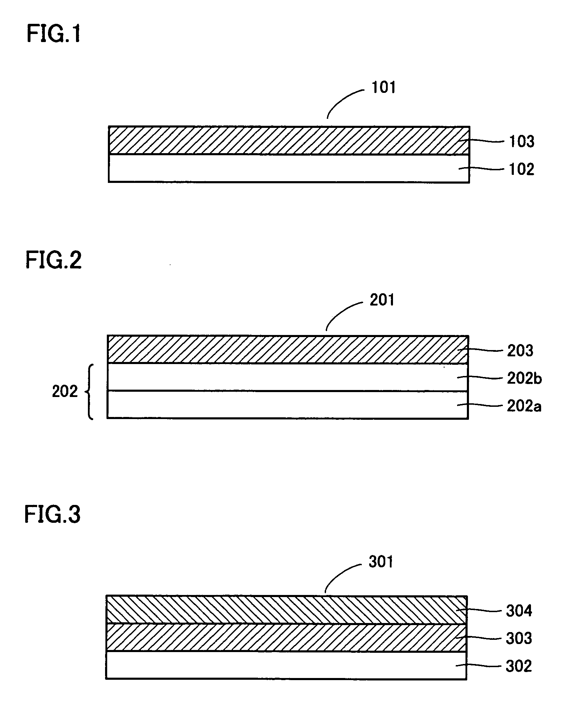

An aluminum stabilization stacked body according to the present invention will be described element by element referring to Figs. 1-3.

### <Thin Film Having Surface formed with Aluminum>

A thin film 102, 202, 302 having a surface formed with aluminum, which is a base of an aluminum stabilization stacked body 101, 201, 301 according to the present invention, includes any kind of thin film formed with aluminum itself, and it also includes a thin film having a layer formed with aluminum formed on a surface of a material other than aluminum. More specifically, the thin film formed with aluminum itself includes, for example, aluminum foil, and it is particularly preferable to use the aluminum foil having a thickness of 4-200 µm. This relates to a stabilization layer described below which is stacked with any of a sputtering method, a deposition method and an ion plating method. That is, the thickness not within the aforementioned range is disadvantageous to adapt each of the methods. When the thickness is less than 4 µm, rolling of aluminum itself is difficult, which increases a cost thereof, and processing with each of the methods also becomes difficult in terms of strength. When the thickness is more than 200 µm, the processing with each of the methods cannot be performed in a form of a roll, which substantially decreases processing efficiency, and other processing method such as clad processing will be more advantageous in terms of cost.

On the other hand, the thin film having a layer formed with aluminum formed on a surface of a material other than aluminum includes, for example, a thin film formed by plating, depositing or sputtering with aluminum or affixing of aluminum foil to any conventionally known material for use in electrical and electronic parts, a semiconductor circuit, a product related to an automobile, or the like, such as a metal other than aluminum, ceramics or a synthetic resin, for example, as the material other than aluminum. More specifically, a suitable example includes a thin film formed by affixing a polymer film 202a to aluminum foil 202b. Examples of the polymer film include a synthetic resin film, a thermoplastic elastomer film and a rubber film. Examples of the synthetic resin film include films made of synthetic resins such as PET, PEN, acryl, nylon, polyethylene, polypropylene, vinyl chloride, polyimide, a liquid crystal polymer, and an epoxy resin. Examples of the thermoplastic elastomer film include films formed with thermoplastic elastomers based on styrene, vinyl chloride, olefin, urethane, ester, amide, and the like. In addition, examples of the rubber film include films formed with natural rubber, or formed with synthetic rubbers such as butadiene rubber, isoprene rubber, chloroprene rubber, styrene-butadiene rubber, nitrile rubber, butyl rubber, ethylene-propylene rubber, acrylic rubber, urethane rubber, fluorocarbon rubber, and silicone rubber. Specific kinds of synthetic resins, thermoplastic elastomers or rubbers are mentioned here only by way of examples and not for limitation. Any kind of filler such as glass fiber can be added to such polymer film to enhance strength or to give a flame resistance effect or the like.

The thin film having the surface formed with aluminum, which is an object of the present invention, may have a two-dimensional or three-dimensional form, as it is obvious from the above description. A form to be a thin film as a whole, however, such as a form of a film, a sheet, a board, or a roll may be particularly suitable. This relates to the stabilization layer described below which is stacked with any of a sputtering method, a deposition method and an ion plating method. That is, with the form as such, the stabilization layer can be stacked with extremely high adhesion.

It is to be noted that, aluminum described above includes a construction formed only with aluminum (which may include a trace quantity of impurity) as well as a construction formed with aluminum as a main component. In addition, though the stabilization layer described below is stacked on a whole surface of the thin film having the surface formed with aluminum as such in the present invention, the "whole surface" here means the whole of the surface which must be stabilized, and it does not mean that a thin film does not belong to a technical range of the present invention if a portion of the surface thereof does not have the stabilization layer stacked thereon. Therefore, it is not necessary to stack the stabilization layer described below on a portion where the stabilization is not required. In addition, it is preferred to perform pretreatment such as degreasing, washing with water or acid activation of the surface formed with aluminum before the stabilization layer described below is stacked. It is because, with this pretreatment, oil or dirt adhered to the surface is removed and adhesion of the stabilization layer is enhanced. In this situation, a conventionally known agent can be used without limitation for the degreasing or the like.

### <Stabilization Layer>

A stabilization layer 103, 203, 303 according to the present invention, which is stacked on a whole surface of the thin film having the surface formed with aluminum, is formed with an unprescribed metal, has a thickness of 0.001-1 µm, and is stacked by any of a sputtering method, a deposition method and an ion plating method. The stabilization layer effectively prevents aluminum of a lower layer from being deteriorated due to oxidation or the like and protects and stabilizes aluminum. A metal for forming the stabilization layer can be Au, Pd, Cu, Ni, Zn, Sn, Fe, Co, Ag, or the like. In particular, among these metals, Cu, Ni, or an alloy including Cu and/or Ni is preferably used. It is because the metal is highly stable and plating with any metal with high adhesion is possible when a plated layer described below is stacked. In addition, besides such plating, subsequent processing such as pressing can be easily performed, and a cost thereof is low and stable since there is abundant resources. Though a composition of the alloy including Cu or Ni is not specifically limited provided that Cu or Ni is included, it can include Pd, Rh, Ru, Co, or the like as a component other than Cu or Ni. In the composition of the alloy as such, a content of Cu or Ni of 20-99.9 mass %, preferably 90-99.5 mass % is suited.

In addition, the thickness of the stabilization layer must be 0.001-1 µm. It is because, the thickness of 1 µm is sufficient to protect and stabilize aluminum, and when the thickness is larger than this, a good surface property inherent in aluminum is impaired. When the thickness is smaller than 0.001 µm, on the other hand, a sufficient stabilization effect cannot be obtained. More preferably, the thickness of 0.01-0.5 µm is suited.

### <Method of Stacking>

When the stabilization layer is stacked on the thin film having the surface formed with aluminum, a method of stacking must be any of a sputtering method, a deposition method and an ion plating method. It is because a whole surface of the thin film having the surface formed with aluminum can be covered uniformly. In particular, when the stacking is performed on a surface of aluminum itself in a form of the thin film such as aluminum foil, the stacking is possible without wrinkling or generating a crack. In the present invention, two or more stabilization layers can be stacked as desired, or the stacking can be performed on both of front and back surfaces of the thin film having the surface formed with aluminum. In this situation, metals forming respective stabilization layers may be the same with each other or may be different, and the thickness of each stabilization layer can be 0.001-1 µm as described above.

The method of stacking will now be described in more detail. As the method of stacking by the sputtering method, the sputtering can be performed in a sputtering apparatus in a vacuum of 1 × 10⁻³ - 7 × 10⁻¹ Pa, preferably 5 × 10⁻³ - 5 × 10⁻² Pa, with 50-300 cc/minute, preferably 180-250 cc/minute of Ar gas, and an output of 0.3-25 kW, preferably 1-20 kW. As the method of stacking by the deposition method, the deposition can be performed in a deposition apparatus in a vacuum of 1 × 10⁻⁵ - 1 × 10⁻³ Pa, preferably 1 × 10⁻⁴ - 1 × 10⁻³ Pa with an output of 5-100 kW, preferably 10-30 kW. As the method of stacking by the ion plating method, the stacking can be performed using an ion plating apparatus and adopting a normal condition corresponding to a kind of metal used.

### <Plated Layer>

While the stabilization layer is stacked on the whole surface of the thin film having the surface formed with aluminum as described above in the present invention, various modification processings of the surface such as processings for electrical conduction, corrosion resistance and decoration become possible by stacking a plated layer 304 on a surface of the stabilization layer. Examples of a metal forming the plated layer include Cu, Ni, Au, Ag, Sn, Pd, Zn, Ru, Rh, and solder, any of which can be selected corresponding to a specific use. In addition, a method of plating may be either of electroless plating and electroplating, and stacking of the layer having a thickness of 0.02-20 µm, preferably 0.1-10 µm can be performed adopting a conventionally known method corresponding to each metal. It is to be noted that, two or more plated layers as such can be stacked and, in this situation, metals forming respective plated layers may be the same with each other or may be different.

Though the present invention will be described in more detail with examples, the present invention is not limited to these examples.

### <Example 1>

As the thin film having the surface formed with aluminum, aluminum foil having a thickness of 25 µm which was rolled to have a form of the thin film was used. The aluminum foil was slit to have a width of 250 mm and a length of 100 m, and then immersed in an immersion bath filled with 50 g/l of Ace Clean 30 (a trade name, produced by Okuno Chemical Industries Co., Ltd.) at a temperature of 50 °C for 1 minute for degreasing. Thereafter, washing with water was repeated for 4 times.

Then, a surface of the aluminum foil degreased as above was immersed in an immersion bath filled with 5 % sulfuric acid at a room temperature for 30 seconds to perform activation processing with the acid. Washing with water was repeated for 3 times, and then drip-drying was performed.

Thereafter, to the surface of the aluminum foil activated as above, sputtering was performed using the sputtering apparatus in which Cu was set to a target and, when a degree of vacuum reached 1.3 × 10⁻² Pa, Ar gas was injected at 250 cc/minute to perform the sputtering with an output of 3 kW and a moving speed of 2 m/minute for 50 minutes to stack the stabilization layer formed with Cu and having a thickness of 0.012 µm (measured with an FIB (Focused Ion Beam) apparatus). As a result, the aluminum stabilization stacked body formed by stacking the stabilization layer formed with Cu on the whole surface of the thin film formed with aluminum was obtained.

A whole surface of the stabilization layer of the aluminum stabilization stacked body obtained as above was immersed in an immersion bath filled with 1 % sulfuric acid at a room temperature for 30 seconds to perform activation processing with the acid. After repeated washing with water for 3 times, electroplating was performed using a continuous electroplating apparatus filled with a plating solution (including 100 g/l of copper sulfate, 160 g/l of sulfuric acid, 60 ppm of chlorine, and 10 cc/l of Top Lucina 380H (produced by Okuno Chemical Industries Co., Ltd.)), in which the aluminum stabilization stacked body was continuously immersed with a moving speed of 2.0 m/minute and was subjected to electroplating at a solution temperature of 30 °C with a current density of 4 A/dm² for 2 minutes to stack the plated layer formed with Cu having a thickness of 1.8 µm (measured with a fluorescent X-ray film thickness measurement apparatus).

Then, after washing with water for 3 times, electroplating was performed using the continuous electroplating apparatus filled with a plating solution (55 g/l of Sn, 120 g/l of Metasu AM (a trade name, produced by Yuken Industry Co., Ltd.) as an organic acid, 50 cc/l of SBS-R (a trade name, produced by Yuken Industry Co., Ltd.)), in which the aluminum stabilization stacked body having the plated layer formed with Cu stacked thereon was continuously immersed with a moving speed of 2.0 m/minute and was subjected to electroplating with Sn at a solution temperature of 35 °C with a current density of 8 A/dm² for 2 minutes to further stack the plated layer formed with Sn having a thickness of 6 µm (measured with the fluorescent X-ray film thickness measurement apparatus) on the plated layer formed with Cu. As a result, the aluminum stabilization stacked body having two plated layers respectively formed with Cu and Sn stacked thereon was obtained.

The aluminum stabilization stacked body obtained was cut into a sample having a certain form and was baked at 150 °C for 4 hours. Thereafter, a bending test was performed in which bending to 90 degrees was repeated for 4 times. As a result, there was no problem with adhesion of the plated layer, and generation of a crack or the like was not observed. In addition, in a solder wettability test at 240 °C, the solder wettability of at least 98 % was shown without any problem. For comparison, similar tests as described above were performed for a sample having two plated layers of Cu and Sn stacked thereon similarly as described above except that the stabilization layer was not formed. As a result, peeling of a whole surface of the plated layer was observed in the bending test. In addition, the solder wettability was 0 % in the solder wettability test and a sufficient solder property was not shown.

### <Example 2>

For the thin film having the surface formed with aluminum, the activation processing with the acid followed by washing with water and drying was performed similarly as described in example 1.

Thereafter, to the surface of the aluminum foil activated as such, sputtering was performed using the sputtering apparatus in which Cu was set to a first target and Ni was set to a second target and, when a degree of vacuum reached 1.3 × 10⁻² Pa, Ar gas was injected at 250 cc/minute for each and outputs were set to 6 kW on a Cu side and to 14 kW on an Ni side to perform the sputtering with a moving speed of 0.5 m/minute for 100 minutes. As a result, the aluminum stabilization stacked body formed by stacking the stabilization layer formed with Ni having a thickness of 0.4 µm (measured with the FIB apparatus) on the stabilization layer formed with Cu having a thickness of 0.2 µm (measured with the FIB apparatus) was obtained.

For the aluminum stabilization stacked body obtained, a corrosion resistance test was performed as follows. In a condition of a temperature of 80 °C and a humidity of 90 % using a high temperature and high humidity test apparatus (manufactured by Tabai Seisakusho KK), corrosivities after 12, 24, 48, and 168 hours were evaluated. No corrosion was evaluated as "A", while corrosion to a degree was evaluated as "B" and substantial corrosion was evaluated as "C". As a comparative example, corrosivities were evaluated in the same condition for a sample not having the stabilization layer stacked thereon (that is, having the surface of aluminum) in this example. The results are shown in Table 1.

**Table 1**

| | 12 hours | 24 hours | 48 hours | 168 hours |
|---|---|---|---|---|
| This Example | A | A | A | A |
| Comparative Example | A | B | C | C |

It is obvious from Table 1 that the corrosion resistance is dramatically enhanced and deterioration due to oxidation is suppressed when the stabilization layer is stacked on the surface of the thin film having the surface formed with aluminum. Industrial Applicability

Since an aluminum stabilization stacked body according to the present invention has a construction such that a whole surface of a thin film having a surface formed with aluminum is protected by a stabilization layer having a thickness of 0.001-1 µm, sufficient protection of aluminum against deterioration due to oxidation or sulfuration is possible. In addition, the stabilization layer is also highly heat-resistant and excellent in various properties such as a solder property because it is formed with a metal. Therefore, the aluminum stabilization stacked body according to the present invention can be widely used as a base material or other material in electrical and electronic parts, a semiconductor circuit, a product related to an automobile or the like for wiring, electrical conduction, a circuit, bonding, soldering, a contact (such as a contact point, a connector, a relay or a switch), shielding, decoration, or the like.

## Claims

1. An aluminum stabilization stacked body (101) formed by stacking a stabilization layer (103) formed with a metal and having a thickness of 0.001-1 µm with any of a sputtering method, a deposition method and an ion plating method on a whole surface of a thin film (102) having a surface formed with aluminum.

2. The aluminum stabilization stacked body (101) according to claim 1, wherein
the thin film (102) having the surface formed with aluminum is aluminum foil rolled to have a thickness of 4-200 µm.

3. The aluminum stabilization stacked body (201) according to claim 1, wherein
the thin film (202) having the surface formed with aluminum is formed by affixing a polymer film (202a) to aluminum foil (202b).

4. The aluminum stabilization stacked body (101) according to claim 1, wherein
the metal is any of Cu, Ni, and an alloy including Cu and/or Ni.

5. The aluminum stabilization stacked body (301) according to claim 1, wherein
a plated layer (304) is stacked on a surface of the stabilization layer.

## Amended claims

### Amended claims under Art. 19.1 PCT

**1.** (Amended) An aluminum stabilization stacked body (301) formed by stacking a stabilization layer (303) formed with a metal and having a thickness of 0.001-1 µm with any of a sputtering method, a deposition method and an ion plating method on a whole surface of a thin film (302) having a surface formed with aluminum and stacking a plated layer (304) on a surface of the stabilization layer (303).

**2.** (Amended) The aluminum stabilization stacked body (301) according to claim 1, wherein
the thin film (302) having the surface formed with aluminum is aluminum foil rolled to have a thickness of 4-200 µm.

**3.** (Amended) The aluminum stabilization stacked body according to claim 1, wherein
the thin film having the surface formed with aluminum is formed by affixing a polymer film to aluminum foil.

**4.** (Amended) The aluminum stabilization stacked body (301) according to claim 1, wherein
the metal is any of Cu, Ni, and an alloy including Cu and/or Ni.

**5.** (Canceled)
